**Europäisches Patentamt**

**European Patent Office**

**Office européen des brevets**

(19)

(11) Veröffentlichungsnummer : **0 413 266 B1**

(12) # EUROPÄISCHE PATENTSCHRIFT

(45) Veröffentlichungstag der Patentschrift :
27.12.95 Patentblatt 95/52

(51) Int. Cl.$^6$ : **G01R 33/54**

(21) Anmeldenummer : **90115356.9**

(22) Anmeldetag : **10.08.90**

(54) **Verfahren zur simultanen Messung von NMR-Signalen, insbesondere zur Bestimmung von Flussgeschwindigkeiten in der Kernspintomographie mit Hilfe der Multiple Slice Fourier Flow (=MUFF) Methode**

(30) Priorität : **16.08.89 DE 3926889**

(43) Veröffentlichungstag der Anmeldung :
**20.02.91 Patentblatt 91/08**

(45) Bekanntmachung des Hinweises auf die Patenterteilung :
**27.12.95 Patentblatt 95/52**

(84) Benannte Vertragsstaaten :
**CH DE FR GB LI**

(56) Entgegenhaltungen :
**EP-A- 0 209 375
EP-A- 0 213 858
US-A- 4 602 641
US-A- 4 843 322**

(56) Entgegenhaltungen :
**MAGNETIC RESONANCE IN MEDICINE, vol. 6, no. 3, März 1988, DULUTH, MN, US; Seiten 364-371; S. MUELLER: "Multifrequency selective rf pulses for multislice MR imaging"
MAGNETIC RESONANCE IN MEDICINE, vol. 3, no. 1, Februar 1986, DULUTH, MN, US; Seiten 105-111; J.B. RA et al.:
"Quadrature-Multiplexed rf excitation for ..."**

(73) Patentinhaber : **SPECTROSPIN AG
Industriestrasse 26
CH-8117 Fällanden (CH)**

(72) Erfinder : **Hennig, Jürgen
Johann-von Weerthstrasse 12
D-7800 Freiburg (DE)**

(74) Vertreter : **KOHLER SCHMID + PARTNER
Patentanwälte
Ruppmannstrasse 27
D-70565 Stuttgart (DE)**

EP 0 413 266 B1

EP 0 413 266 B1

## Beschreibung

Die Erfindung betrifft ein Verfahren zur simultanen Messung von Spin-Resonanz-Signalen, insbesondere NMR-Signalen, aus n Schichten unterschiedlicher Tiefe z in einem Meßvolumen, welches einem homogenen Magnetfeld in Z-Richtung und periodisch aufeinander folgenden Sequenzen von pulsförmig angelegten Gradientenfeldern sowie zu den Gradientenfeldern zeitlich synchronisierten zusammengesetzten HF-Anregungspulsen $P_k$ ausgesetzt wird, die jeweils aus einem einzigen, aus der Überlagerung mehrerer unterschiedlicher Frequenzen aufgebauten HF-Puls bestehen, und deren n Einzelkomponenten $P_m$ aufgrund ihrer jeweiligen Frequenz $\omega_m$ selektiv in einer bestimmten Schicht m des Meßvolumens eine Spin-Resonanz mit der Larmorfrequenz $\omega_m$ anregen, wobei eine räumliche Variation der Larmorfrequenzen $\omega_m$ in Z-Richtung durch Anlegen eines Schichtselektionsgradienten bewirkt wird, wobei die Einzelkomponenten $P_m$ des zusammengesetzten HF-Anregungspulses $P_k$ jeweils einen Phasenversatz $\phi_m$ aufweisen, der von einer Sequenz zur nächsten durch sukzessive Addition eines für jede Einzelkomponente $P_m$ individuellen, konstanten Phaseninkrementes $\Delta\phi_m$ modulo 360° variiert wird, und wobei ein vollständiger Meßzyklus aus n oder einem ganzzahligen Vielfachen von n Sequenzen besteht, deren Meßsignale einer Fourier-Transformation unterworfen werden, die auch eine Transformation bezüglich der durch die Anregungspulse vorgenommenen Phasenkodierung der unterschiedlichen Schichten beinhaltet.

Aus der US-A-4 843 322 ist ein Verfahren bekannt, bei dem die Einzelkomponenten des zusammengesetzten HF-Anregungspulses jeweils einen Phasenversatz $k_y y_o$ aufweisen, der von einer Sequenz zur nächsten durch sukzessive Addition eines für jede Einzelkomponente individuellen, konstanten Phaseninkrements (delta $k_y$) $y_o$ variiert wird, wobei ein Meßzyklus aus einer der Zahl der Schichten proportionalen Anzahl von Sequenzen besteht.

Ein ähnliches Verfahren ist auch aus Magn. Res. Med. 6 (1988) 364-371 bekannt. Dieses Verfahren deckt sich jedoch nur für n=2 Schichten mit dem eingangs beschriebenen Verfahren, da als Phaseninkremente nur 0° bzw. 180° dienen, und daher für n>2 der Phasenversatz mancher Einzelkomponenten nicht bei jeder neuen Sequenz inkrementiert wird.

Ähnliche Verfahren sind auch aus der Kernspin-Tomographie bekannt, insbesondere bei den zwei- oder dreidimensionalen Imaging-Techniken. Soll ein dreidimensionales Bild von physikalischen Eigenschaften einer Probe wie Spindichte oder Flußgeschwindigkeit mit Hilfe von 3DFT-Techniken erzeugt werden, so ist dies nur durch sukzessive Messung vieler aufeinander folgender zweidimensionaler Ausschnitte aus dem Meßvolumen möglich, was sehr zeitaufwendig, und daher bei der Bestimmung transienter Vorgänge, wie sie typischerweise bei Strömungsmessungen auftreten, denkbar ungeeignet ist. Es sind zwar auch 3DFT-Verfahren bekannt, bei denen eine Vielzahl von scheibenförmigen Schichten im Meßvolumen gleichzeitig durch einen zusammengesetzten Anregungspuls eine Spin-Anregung erfahren, jedoch müssen die einzelnen untersuchten Schichten im Meßvolumen kohärent aufeinanderfolgend sein, so daß die Aussparung uninteressanter Raumgebiete im Beobachtungsvolumen bei diesen Verfahren nicht möglich ist.

Probleme bei der praktischen Anwendung der simultanen Anregung mehrerer Schichten können sich dadurch ergeben, daß die verwendeten HF-Anregungspulse bereits bei wenigen simultan anzuregenden Schichten (n>3) Maxima der Pulsamplituden aufweisen, die gegenüber der Aufnahme einer Einzelschicht um das n-fache erhöht sind. Gleichzeitig werden jedoch außerhalb der Pulsmaxima lediglich Modulationen mit um mehr als zwei Größenordnungen geringerer Amplitude erforderlich. Die auftretenden Leistungsspitzen können die für Patientenuntersuchungen zulässigen Grenzwerte leicht überschreiten.

Aufgabe der vorliegenden Erfindung ist es daher, ein Verfahren nach dem Oberbegriff des Hauptanspruchs vorzustellen, bei dem die simultane Messung der magnetischen Resonanzsignale von parallelen Einzelschichten an beliebigen Stellen des Objektes durchgeführt werden können, wobei die Einzelkomponenten in einer Art und Weise überlagert werden, die zu einer Minimierung der eingestrahlten Hochfrequenzleistung führt, so daß auch Aufnahmen mit n>3 durchgeführt werden können, ohne daß Grenzwerte der HF-Belastung bei in vivo-Anwendungen am Menschen überschritten werden. Diese Aufgabe wird dadurch gelöst, daß der Phasenversatz $\phi_m$ der n Einzelkomponenten $P_m$ in der ersten Sequenz des Meßzyklus den Wert einer Startphase $\phi^\circ_m$ annimmt, wobei die n Startphasen $\phi^\circ_m$ derart gewählt werden, daß in jeder Sequenz sich mindestens ein Phasenversatz $\phi_m$ von den anderen Phasenversätzen der Sequenz unterscheidet, und zwar derart, daß die aus einer vektoriellen Addition der Amplitude der Einzelkomponenten $P_m$ an einem dem Zentrum des jeweiligen Pulses entsprechenden Zeitpunkt $t_0$ resultierende Gesamtamplitude des HF-Anregunspulses $P_k$ bei allen Sequenzen gleich ist.

Dadurch wird die sehr hohe Amplitudenspitze des HF-Pulses der ersten Sequenz drastisch vermindert und die entsprechend reduzierte Leistungsspitze auf die HF-Pulse der anderen Sequenzen verteilt, die ohne diese Maßnahme destruktiv interferieren und bei $t_0$ Amplituden von Null aufweisen würden. Im Idealfall einer völligen Gleichverteilung beträgt bei auf 1 normierten Amplituden der n Einzelkomponenten $P_m$ die Amplitude der HF-

2

Anregungspulse $P_k$ jeweils $\sqrt{n}$. Diese drastische Reduktion der Amplitudenspitze des Anregungspulses der ersten Sequenz erlaubt auch bei Überlagerung vieler Einzelkomponenten $P_m$ den in-vivo-Einsatz des erfindungsgemäßen Verfahrens, da damit die zugelassenen Höchstwerte der Belastung des zu untersuchenden Patienten in aller Regel weit unterschritten werden können.

Durch die Zuordnung des individuellen Phasenversatzes $\phi_m$ einer Einzelkomponente $P_m$ aus dem HF-Anregungspuls $P_k$ zu der von dieser Einzelkomponente $P_m$ angeregten Schicht m kann nach erfolgter Fourier-Transformation aus dem Summensignal eines Meßzyklus bei der Darstellung des Ergebnisses eine nachträgliche Aufspaltung in die Signale aus den einzelnen Schichten m erfolgen. Ein weiterer Vorteil besteht darin, daß in der Darstellung die Signale aus den einzelnen Schichten in beliebiger Reihenfolge kombinierbar sind.

Aus dem oben zitierten US-Patent 4,843,322 ist zwar bekannt, daß ein zusammengesetzter Anregungspuls Terme enthalten kann, die mit einem $k_y$-abhängigen Phasenfaktor moduliert sind, der die Bilder aus jeder angeregten Schicht bei der Rekonstruktion voneinander unterscheidbar macht. Die genannte Druckschrift behandelt aber lediglich Bildgebungsverfahren für statische Bilder; es ist ihr kein Hinweis auf eine simultane dynamische Messung mehrerer Strömungsquerschnitte in einem einzigen Aufnahmezyklus zu entnehmen.

Bei einer bevorzugten Ausführungsform des erfindungsgemäßen Verfahrens werden demgegenüber mittels eines bipolaren Phasenkodiergradienten nach dem Fourier-Flow-Verfahren Flußgeschwindigkeiten eines im Meßvolumen strömenden Mediums schichtselektiv bestimmt. Damit ist die simultane Messung mehrerer Strömungsquerschnitte in einem einzigen Aufnahmezyklus möglich.

Der im weiteren verwendete Begriff "Fourier Flow" ist der Fachwelt beispielsweise aus dem Artikel "Quantitative Flow Measurement With The Fast Fourier Flow Technique" von Hennig et al. in der Zeitschrift American Journal of Radiology, Vol. 166, No. 1, Seiten 237-240, 1988 bekannt. Das Grundprinzip der Flußmessung nach dem Fourier-Flow-Prinzip, wie es beispielsweise aus einem Artikel von Feinberg et al. in der Zeitschrift American Journal of Radiology, Vol. 163, No. 3, Seiten 793-799, 1987 beschrieben ist, sieht die Verwendung eines Phasencodiergradienten für eine Bildaufnahme nach dem Verfahren der 2-dimensionalen Fourier Transformation vor, wobei der Gradient in zwei Schritten in der Weise angelegt wird, daß keine dephasierende Wirkung auf stationäre Spins ausgeübt wird, während fließende Spins eine ihrer Geschwindigkeit und der Gradientenstärke proportionale Dephasierung erfahren.

Bei einer weiteren Ausgestaltung des erfindungsgemäßen Verfahrens wird durch Zusammensetzen einer Vielzahl von aufgenommenen Strömungsprofilen eine qualitative räumliche Darstellung der durchströmten Volumina erreicht. Dies ermöglicht insbesondere bei Anwendungen in der Medizin die dreidimensionale Rekonstruktion der entsprechenden durchströmten Gefäße (MR-Angiogramm).

Dabei kann es von Vorteil sein, wenn die Gradientensequenz in der sogenannten Cine-Mode mit dem EKG-Zyklus synchron läuft. Dies ermöglicht bei Herzaufnahmen eine Verringerung von Bewegungsartefakten durch das pulsierende Herz.

Wie beispielsweise aus einem Artikel Sechtem et al. in American Journal of Radiology, Vol. 148, Seiten 239 ff., 1987 bekannt ist, wird der Begriff "cine mode" für ein NMR-Aufnahmeverfahren verwendet, bei dem mehrere Bilder in einer bestimmten zeitlichen Reihenfolge aufgenommen und hinterher wie bei einem Film wieder abgespielt werden.

Bei einer weiteren Ausführungsform des erfindungsgemäßen Verfahrens verwendet man statt eines Gradientenschemas nach dem Fourier-Flow-Prinzip eine Phasencodierung entsprechend einem 2DFT-Bildgebungsexperiment (Gradienten-Echo-oder Spin-Echo-2DTF-Verfahren), wobei im Falle des Spin-Echo Verfahrens das Beobachtungsfenster jeder Schicht durch einen in Richtung des Phasengradienten scheibenselektiven Anregungs- oder Refokussierungspuls eingeschränkt wird. Damit lassen sich simultan mehrere Scheiben als Bild darstellen, wobei die Bilder der einzelnen Scheiben nebeneinander erscheinen.

Auch bei dieser Ausführungsform kann es von Vorteil sein, die Aufnahme in EKG-getriggertem Aufnahmemodus durchzuführen, um bei Herzuntersuchungen Bewegungsartefakte zu verringern.

Bei einer weiteren Ausführungsform erfolgt die Phasencodierung für die 2DFT-Bildrekonstruktion ausschließlich über die Phasenmodulation der Pulse, wodurch das Beobachtungsfenster der verwendeten Pulssequenz in Phasenrichtung eingeschränkt wird, so daß nur der relevante Bereich jeder Scheibe zur Abbildung kommt.

Bei einer weiteren vorteilhaften Ausführungsform schließlich wird die räumliche Auflösung der Spin-Resonanzsignale ausschließlich durch Phasenmodulation der HF-Anregungspulse $P_k$ in einem gradientenkodierten chemical-shift-imaging-Verfahren bewirkt. Gerade beim chemical-shift-imaging stellt sich besonders drastisch das Problem einer Kontamination der NMR-Signale in benachbarten und sogar weiter entfernten Bildpunkten ("Voxel") durch eine Dephasierung der Signale aufgrund eines angelegten Phasengradienten. Oft sollen sehr kleine Signale in einem Voxel beobachtet werden, während im Nachbarvoxel eine sehr große Konzentration von Spins mit gleichem Signal existiert, so daß schon geringe Kontamination das Meßergebnis aus dem zu beobachtenden Voxel überdeckt. Da bei dem erfindungsgemäßen Verfahren jedoch sämtliche Spins in der jeweiligen Schicht denselben Phasenversatz erfahren, wird die Dephasierung vermieden. Daher wird bei Verwendung von HF-Anregungspulsen $P_k$ gemäß der Erfindung der Kontaminationseffekt bei gradientenkodiertem chemical-shift-imaging minimiert.

Die Erfindung wird im folgenden anhand der in der Zeichnung dargestellten Ausführungsbeispiele näher beschrieben und erläutert. Es zeigen:

Fig. 1        das Zeitdiagramm der Aufnahmesequenz einer Ausführungsform des erfindungsgemäßen Verfahrens mit bipolaren Phasenkodiergradienten,

Fig. 2a        den schematischen Versuchsaufbau eines Multiple-Slice Experiments mit einem Y-förmigen Rohr,

Fig. 2b        das Meßergebnis eines Fourier-Flow Experimentes an dem Versuchsaufbau von Fig. 2a,

Fig. 2c        das Meßergebnis eines MUFF-Experimentes an dem Versuchsaufbau aus Fig. 2a,

Fig. 3a        die Meßergebnisse eines MUFF-Experiments in dem Versuchsaufbau aus Fig. 2a mit sehr vielen angeregten Profilen,

Fig. 3b        ein aus den Ergebnissen von Fig. 3a konstruiertes MR-Angiogramm,

Fig. 4        ein Pulsprofil eines MUFF-Pulses mit Startphasen von 0° für alle Einzelkomponten $P_m$, und

Fig. 5        ein Pulsprofil mit optimierter maximaler Pulsamplitude.

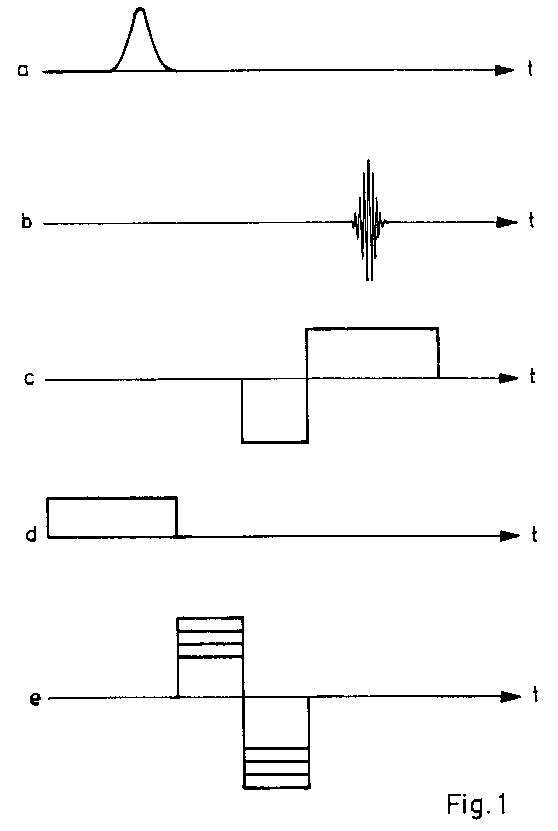

Das in Fig. 1 dargestellte Schema zeigt die zeitliche Abfolge der Pulssequenz einer Ausführungsform des erfindungsgemäßen Verfahrens mit einer aus der Fast-Fourier-Flow Technik bekannten Pulsfolge, bei welcher durch eine Phasenkodierung mit Hilfe eines bipolaren Gradientenpulses direkt die Flußgeschwindigkeit in einem mehrdimensionalen Fourier-Transformations-Experiment bestimmt wird. Es handelt sich dabei um ein NMR-Verfahren, bei dem während der gesamten Messung ein homogenes Magnetfeld in Z-Richtung sowie in periodisch aufeinander folgenden Sequenzen die in Fig. 1 schematisch dargestellten pulsförmigen Gradientenfelder und zeitlich damit synchronisierte, zusammengesetzte HF-Anregungspulse $P_k$ auf ein Meßvolumen einwirken. Der Anregungspuls $P_k$ entsteht aus einer Überlagerung von n Einzelkomponenten $P_m$.

Das Anregungsprofil einer Einzelkomponente $P_m$ läßt sich beschreiben als:

$$P_m = S(m) \cdot \exp(i\omega_m(t - t_0)), \quad (1)$$

wobei S(m) die Einhüllende des Pulses beschreibt, welche nach dem Stand der Technik z.B. einer Gaussfunktion, einer Funktion sinx/x, einer Hermite-funktion etc. entsprechen kann. Dabei ist $\omega_m$ die Larmorfrequenz, bei der in einer Schicht m Resonanzanregung erfolgte, t bezeichnet die Zeitkoordinate und $t_0$ entspricht dem Zeitpunkt im Zentrum des Pulses.

Ein in Fig. 1 in Zeile (a) dargestellter zusammengesetzter Anregungspuls $P_k$, welcher beschrieben wird, durch

$$P_k = \sum_{m=1}^{n} S(m) \cdot \exp(i \cdot \omega_m \cdot (t - t_0)), \quad (2)$$

wobei alle $\omega_m$ soweit unterschiedlich sind, daß die durch die Modulationsfunktion bestimmte Anregungsbandbreite der jeweiligen Einzelkomponenten nicht überlappt, wird danach simultan zur Anregung von n Profilen führen, wenn gleichzeitig der in Zeile (d) dargestellte Schichtselektionsgradient für eine definierte Variation des auf das Meßvolumen wirkenden effektiven Magnetfelds und somit für eine entsprechende Variation der Larmorfrequenz in Z-Richtung sorgt.

Anschließend wird durch eine Phasenkodierung mit Hilfe des in Zeile (e) dargestellten bipolaren Flußkodiergradienten nach der "Fast-Fourier-Flow-Technique" direkt die Flußgeschwindigkeit eines im Meßvolumen strömenden Mediums simultan für alle n angeregten Schichten bestimmt. Das resultierende Gradientenechosignal ist in Fig. 1 in Zeile (b), der gleichzeitig angelegte Auslesegradient in Zeile (c) dargestellt.

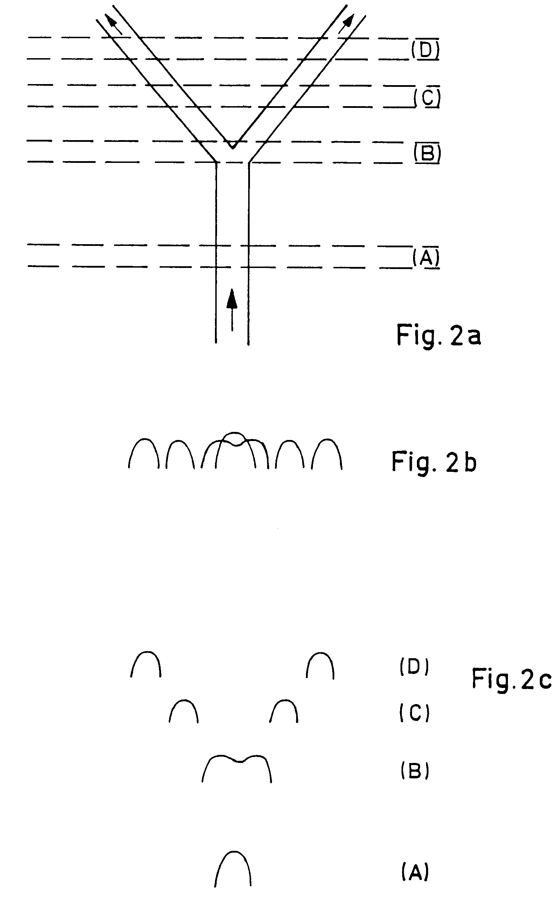

Fig. 2a zeigt schematisch einen einfachen Versuchsaufbau mit einem Y-förmigen Rohr, welches in Pfeilrichtung von Wasser durchströmt wird. (A), (B), (C) und (D) bezeichnen die Lage der angeregten Schichten.

Bei Auslesen der Meßergebnisse nach dem in Fig. 1 gezeigten Schema ergibt sich dann als Resultat des Experimentes die in Fig. 2b abgebildete Überlagerung aller angeregter Strömungsprofile.

Eine solche Darstellung ist in der Praxis nicht zweckmäßig, da hierbei die Information darüber, welches Profil welchem Querschnitt entspricht, verlorengeht.

Eine wesentlich zweckmäßigere Art der Auslesung wäre die, daß die einzelnen Profile im Bild separiert erscheinen.

Der entscheidende, der Erfindung zugrunde liegende Schritt hierzu besteht darin, daß die Phase der n Einzelpulse so moduliert wird, daß sich nach der Fouriertransformation die erwünschte Separation der Profile ergibt.

Gleichung (2) muß daher um einen Term ergänzt werden, welcher der Phasenmodulation jedes einzelnen Pulses entspricht:

$$P_k = \sum_{m=1}^{n} S(m) \cdot \exp(i \cdot (\omega_m \cdot (t-t_0) + \phi_m) \cdot \qquad (3)$$

Der Phasenversatz $\phi_m$ wird dabei von einer Anregung zur nächsten variiert, daß die Phase jedes Pulses um ein konstantes Phaseninkrement $\Delta\phi_m$ inkrementiert wird. Nimmt man z.B. den Fall der Überlagerung zweier Pulse mit unterschiedlicher Frequenz und läßt die Phase des ersten Pulsanteils konstant, alterniert jedoch die Phase desjenigen Pulsanteils, welcher die zweite Schicht anregt. so erscheint nach dem Sampling-Theorem der Fouriertransformation das Profil der zweiten Schicht um eine halbe Bildbreite verschoben.

Für die Überlagerung von vier Schichtprofilen, welche um jeweils 1/4 der Bildgröße in Phasenrichtung voneinander entfernt erscheinen sollen (Fig. 2c) ergibt sich folgender Phasenzyklus:

| k | $\phi_1$ | $\phi_2$ | $\phi_3$ | $\phi_4$ |
|---|---|---|---|---|
| 1 | 0 | 0 | 0 | 0 |
| 2 | 0 | 90 | 180 | 270 |
| 3 | 0 | 180 | 0 | 180 |
| 4 | 0 | 270 | 180 | 90 |

Tabelle 1

Die Phasenwinkel sind hierbei jeweils in Grad wiedergegeben und k bezeichnet die jeweilige Pulsnummer im Zyklus.

Für den Fall eines Experimentes mit n=8 simultan angeregten Scheiben ergeben sich die folgenden einzelnen Phasen $\phi_m$ (in Grad) der 8 zusammengesetzten Pulse, die bei zyklischer Wiederholung zu der gewünschten Separation der Einzelbilder um 1/8 der Bildgröße in Phasenrichtung führen;

| k | $\phi_1$ | $\phi_2$ | $\phi_3$ | $\phi_4$ | $\phi_5$ | $\phi_6$ | $\phi_7$ | $\phi_8$ | Amplitude $P_k$ |
|---|---|---|---|---|---|---|---|---|---|
| 1 | 0 | 0 | 0 | 0 | 0 | 0 | 0 | 0 | 8 |
| 2 | 0 | 45 | 90 | 135 | 180 | 225 | 270 | 315 | 0 |
| 3 | 0 | 90 | 180 | 270 | 0 | 90 | 180 | 270 | 0 |
| 4 | 0 | 135 | 270 | 45 | 180 | 315 | 90 | 225 | 0 |
| 5 | 0 | 180 | 0 | 180 | 0 | 180 | 0 | 180 | 0 |
| 6 | 0 | 225 | 90 | 315 | 180 | 45 | 270 | 135 | 0 |
| 7 | 0 | 270 | 180 | 90 | 0 | 270 | 180 | 90 | 0 |
| 8 | 0 | 315 | 270 | 225 | 180 | 135 | 90 | 45 | 0 |

Tabelle 2

Die letzte Spalte gibt die durch vektorielle Addition gewonnene Pulsamplitude $P_k$ des k-ten Pulses im Zyklus für $t=t_0$ (Pulsmitte) wieder.

Für eine beliebige Anzahl n von angeregten Profilen ergeben sich entsprechend die Phaseninkremente

$$\Delta\phi_m = 0, 360°/n, 2\cdot360°/n, 3\cdot360°/n, ...., (n - 1)\cdot360°/n$$

für die jeweiligen Pulsanteile.

Der Phasenzyklus wird jeweils zyklisch wiederholt, bis alle zur zweidimensionalen Fouriertransformation benötigten Phasenkodierschritte (i.a. 128 oder 256) abgearbeitet sind. Der bipolare Gradient wird dabei von Anregung zu Anregung fortgeschaltet, so daß alle n Profile ohne Verlängerung der Aufnahmezeit simultan erhalten werden.

Allgmein läßt sich zeigen, daß zur Anregung von n Scheiben eine zyklische Wiederholung von n Pulsen ausreicht. Das Pulsprofil des k-ten Pulses im Zyklus läßt sich dann beschreiben durch

$$P_k = \sum_{m=1}^{n} S(m) \cdot \exp\left(i \cdot \omega_m (t-t_0) + (k-1) \cdot \Delta\phi_m\right)$$

$$= \sum_{m=1}^{n} S(m) \cdot \exp\left(i \cdot \omega_m (t-t_0) + (k-1)\cdot(m-1)\cdot360°/n\right) \quad (4)$$

Eine zweckmäßige Ausführung der erfindungsgemäßen Anregungssequenz erzeugt die zur simultanen Aufnahme von n Strömungsprofilen notwendigen n unterschiedlichen Anregungspulse digital als n unterschiedlich amplituden- und phasenmodulierte Pulse entsprechend Gleichung (4). Eine analoge Erzeugung der Pulsprofile durch elektronische Mischung der jeweiligen Einzelpulse ist zwar vom Konzept her einfacher, erfordert jedoch eine wesentlich aufwendigere elektronische Ausstattung mit n amplituden- und phasenmodulierten Kanälen zur Pulserzeugung, während bei digitaler Mischung das Gesamtprofil in nur einem Kanal erzeugt werden kann.

Da das Auftreten der einzelnen Profile im Bild nur von der Phasenmodulation $\Delta\phi_m$ der einzelnen Pulse abhängt, nicht jedoch von der Anregungsfrequenz $\omega_m$ und damit der Lage der Scheiben im Raum, können die einzelnen Profile auf dem Bild unabhängig von ihrer räumlichen Lage angeordnet werden. So können durchaus Profile mit unterschiedlichem räumlichen Abstand im Bild äquidistant erscheinen. Sofern dies zweckmäßig erscheint, läßt sich durch entsprechende Wahl von $\Delta\phi_m$ sogar die Reihenfolge der Scheiben im Bild verändern.

Die Grundidee der Phasenkodierung von Profilen nicht über einen Phasenkodiergradienten, sondern über die Phase mehrscheibenselektiver Pulse läßt sich in weiteren Ausführungsformen der Erfindung nutzvoll anwenden:

Unter Beibehaltung des oben beschriebenen grundsätzlichen Pulsschemas einer Fast-Fourier-Flow-Sequenz läßt sich eine Variante des Verfahrens realisieren, bei welcher

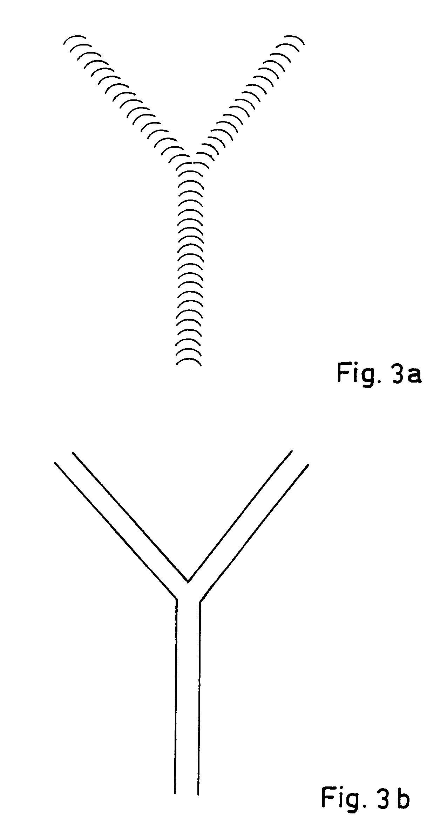

- die Dicke der angeregten Scheiben nur wenige mm beträgt,
- die durch das jeweilige Phaseninkrement $\Delta\phi_m$ bestimmte Lage der Profile der räumlichen Lage im Körper entspricht,
- die durch den bipolaren Gradienten bestimmte Geschwindigkeitsempfindlichkeit der Sequenz so gewählt wird, daß die Profile nicht oder zumindest nicht störend überlappen. Unter Einhaltung dieser Bedingung lassen sich die gewonnenen Strömungsprofile, wie in Fig. 3a gezeigt, dann so zusammensetzen, daß neben der Bestimmung der Strömungsgeschwindigkeit eine rekonstruierte Darstellung des Gefäßverlaufs erfolgen kann (Fig. 3b). Die beschriebenen Verfahren können auch derart modifiziert werden, daß die Sequenz in sog. cine-mode mit dem EKG-Zyklus synchron abläuft, und zwar derart, daß mehrere (typisch 20) aufeinanderfolgende momentane Strömungsprofile gemessen werden, so daß die Änderung der Strömungsgeschwindigkeit in Arterien über den EKG-Zyklus gemessen werden kann.

Die Phasenkodierung über die konsekutive Erhöhung der Phase der Pulsanteile läßt sich zur reinen Bildgebung ausnützen. Verwendet man statt eines Gradientenschaltschemas nach dem Fourier-Flowprinzip eine Phasenkodierung entsprechend einem 2DFT-Bildgebungsexperiment, so lassen sich simultan mehrere Scheiben als Bild darstellen, wobei die Bilder der einzelnen Scheiben nebeneinander erscheinen. Auch diese Variante ist vor allem für funktionelle Untersuchungen wichtig, bei denen es - wie z.B. bei Herzuntersuchungen - auf das Vorliegen von Bildern zum exakt gleichen Zeitpunkt ankommt. Dabei kann eine zweckmäßige Variante des Verfahrens darin bestehend daß das Beobachtungsfenster in der verwendeten Pulssequenz in Phasenrichtung eingeschränkt wird, so daß nur der relevante Bereich jeder Scheibe zur Abbildung kommt. Dies geschieht dadurch, daß bei Verwendung einer Spin-echosequenz entweder der Anregungs- oder der Refokussierungspuls scheibenselektiv in Richtung des Phasenkodiergradienten wirkt. Im Extremfall kann dabei die Zahl der selektierten Scheiben der Zahl der Phasenkodierschritte entsprechen. so daß keinerlei Phasenkodiergradient mehr benötigt wird und die gesamte Phasenkodierung für die 2DFT über die Variation der Phase der Pulse erfolgt.

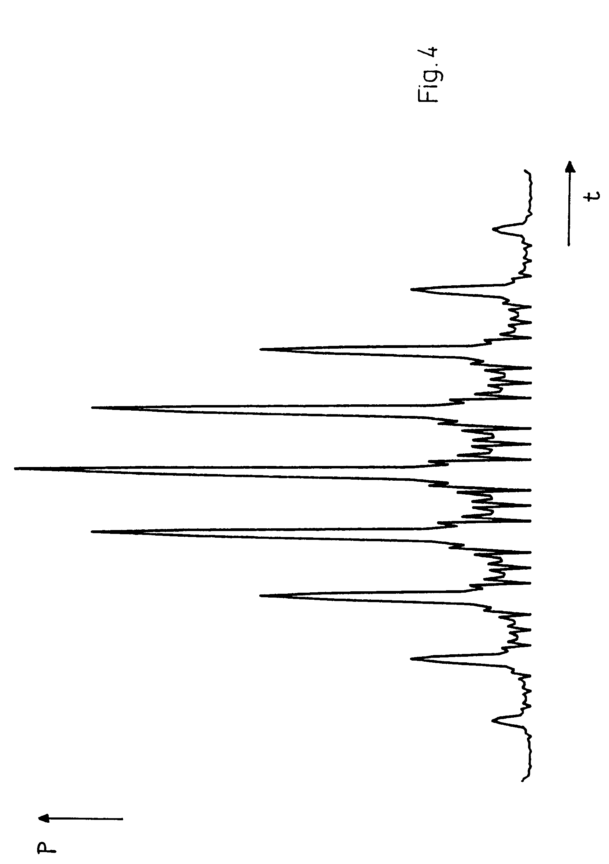

Ein Problem, welches sich in der Praxis bei der Anregung mehrerer Scheiben stellt, ist die Tatsache, daß die maximale Leistung eines Pulses sowohl technisch beschrankt ist, als auch durch Auflagen des Gesetzgebers eine Obergrenze für die Anwendung am Patienten gesetzt werden kann. Bei Pulsen, welche nach obigem Schema durch Überlagerung erzeugt werden, ergibt sich für die maximale Leistung das $n^2$-fache der zur Anregung einer Einzelschicht benötigten Leistung. Fig. 4 zeigt ein Beispiel für einen solchen Puls. Die hohen Leistungsspitzen dieses Pulses sind durch die Kohärenz der Einzelkomponenten $P_m$ bedingt, welche sich im Pulszentrum gleichphasig überlagern.

Diese Peak-Leistung läßt sich jedoch reduzieren, wenn man beachtet, daß die Pulse nlcht notwendigerweise alle die Startphase 0° - wie in obigem Schema - im ersten Puls besitzen müssen. Eine Änderung der Startphase zieht keinerlei Änderung im resultierenden Bild nach sich, da die dadurch bewirkte Phaseninformation auf Grund der üblichen Betragswertbildung nach der Fouriertransformation verloren geht.

Berechnet man die Amplitude des Gesamtpulses durch vektorielle Addition der Pulsamplituden aus obigem Schema (letzte Spalte in Tabelle 2) und wählt als für die Pulsleistung repräsentativen Zeitpunkt den Zeitpunkt $t_0$ des Pulsmaximums, so erkennt man, daß der erste Puls eine sehr hohe Leistungsspitze besitzt, während alle anderen Pulse destruktiv interferieren. Außerhalb des Pulsmaximums ist die Amplitude dieser Pulse aufgrund der unterschiedlichen Frequenzen der Einzelpulse ungleich Null.

Da eine Änderung der Startphase keine Änderung des Gesamtbetrags der Amplituden über sämtliche Pulse bewirken kann, ergibt sich aus Tabelle 2 automatisch, daß dieser Gesamtbetrag gleich dem n-fachen der Amplitude eines zur Einzelschichtanregung verwendeten Pulses sein muß. Die Startphase der Pulse läßt sich so variieren, daß diese Gesamtamplitude gleichmäßig auf alle Pulse verteilt wird.

Da der Gesamtbetrag bei vektorieller Addition der Wurzel aus der Summe der Betragsquadrate entspricht, ergibt sich bei völliger Gleichverteilung und jeweils auf 1 normierten Amplituden der Einzelkomponenten $P_m$ eine Amplitude von $\sqrt{n}$ für jeden Puls, für n=8 also $2 \cdot \sqrt{2}$. Dies wird mit folgendem in Tabelle 3 angezeigten Schema erreicht, wo die Pulsphase bei geänderter Startphase im ersten Puls gezeigt ist und das Phaseninkrement für jede der n Schichten identisch ist:

| k | $\phi_1$ | $\phi_2$ | $\phi_3$ | $\phi_4$ | $\phi_5$ | $\phi_6$ | $\phi_7$ | $\phi_8$ | Amplitude $P_k$ |
|---|---|---|---|---|---|---|---|---|---|
| 1 | 0 | 0 | 0 | 270 | 180 | 0 | 180 | 270 | $2 \cdot \sqrt{2}$ |
| 2 | 0 | 45 | 90 | 45 | 0 | 225 | 90 | 225 | $2 \cdot \sqrt{2}$ |
| 3 | 0 | 90 | 180 | 180 | 180 | 90 | 0 | 180 | $2 \cdot \sqrt{2}$ |
| 4 | 0 | 135 | 270 | 315 | 0 | 315 | 270 | 135 | $2 \cdot \sqrt{2}$ |
| 5 | 0 | 180 | 0 | 90 | 180 | 180 | 180 | 0 | $2 \cdot \sqrt{2}$ |
| 6 | 0 | 225 | 90 | 225 | 0 | 45 | 90 | 45 | $2 \cdot \sqrt{2}$ |
| 7 | 0 | 270 | 180 | 0 | 180 | 270 | 0 | 0 | $2 \cdot \sqrt{2}$ |
| 8 | 0 | 315 | 270 | 135 | 0 | 135 | 270 | 315 | $2 \cdot \sqrt{2}$ |

Tabelle 3

Allgemein gilt für die Form $P_k$ des k-ten Pulses

$$P_k = \sum_{m=1}^{n} S(m) \cdot \exp\left(i \cdot \omega_m (t - t_0) + (k-1) \cdot (m-1) \cdot 360°/n + \phi°_m\right) \qquad (5)$$

wobei $\phi°_m$ die Startphase zur Minimierung der maximalen Pulsleistung bedeutet.

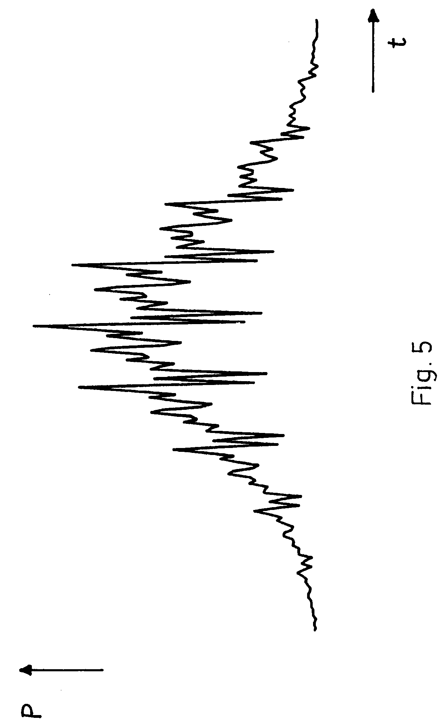

Das Absolutwertprofil eines solchen Pulses ist in Fig. 5 dargestellt. Man sieht die drastische Reduzierung der Amplitude gegenüber dem in Fig. 4 dargestellten Puls.

Im folgenden ist ein einfacher Algorithmus zur Ermittlung der Phasenterme $\phi_m$ für die Homogenisierung der Pulsamplituden im Zentrum des Pulses für $n=2^x$ beschrieben:

Die Summe der Quadrate der Amplituden $P_k$ über alle k ist konstant und gleich $n^2$. Das heißt, der Wert

jeder homogenisierten Amplitude $P_{k0}$ ist gleich $\sqrt{n}$. Eine Konstruktion der entsprechenden Phasen für alle $n=2^x$ läßt sich aus einer Partitionierung der n unterschiedlichen Scheiben m mit verschiedenem Phaseninkrement $(m-1) \cdot 360°/n$ ableiten:

1) $n = 2$, $P_{k0} = \sqrt{2}$

Ignoriert man Rotationen und Translationen, so gibt es für diesen Fall zwei unterschiedliche Möglichkeiten der Kombination der $\phi°_m$:

a)

| k | $\phi_1$ | $\phi_2$ | $P_k$ |
|---|---|---|---|
| 1 | 0 | 0 | 2 |
| 2 | 0 | 180 | 0 |

b)

| k | $\phi_1$ | $\phi_2$ | $P_k$ |
|---|---|---|---|
| 1 | 0 | 90 | $\sqrt{2}$ |
| 2 | 0 | 270 | $\sqrt{2}$ |

Variante b) liefert die gewünschte Homogenisierung der $P_k$.

2) $n = 4$, $P_{k0} = 2$

Aus Schema 1a) folgt unmittelbar, daß die zwei Amplituden derjenigen Teilpulse, deren Phaseninkrement 180° beträgt, sich alternierend addieren und subtrahieren. Daraus lassen sich die Phasen $\phi_m$ für 4 Scheiben leicht ableiten:

| k | $\phi_1$ | $\phi_2$ | $\phi_3$ | $\phi_4$ | $P_{1+3}$ | $P_{2+4}$ | $P_k$ |
|---|---|---|---|---|---|---|---|
| 1 | 0 | 0 | 0 | 180 | 2 | 0 | 2 |
| 2 | 0 | 90 | 180 | 90 | 0 | 2 | 2 |
| 3 | 0 | 180 | 0 | 0 | 2 | 0 | 2 |
| 4 | 0 | 270 | 180 | 270 | 0 | 2 | 2 |

3) $n = 4^x$, $P_{k0} = 2^x$

Für 4-er Potenzen läßt sich der Gesamtpuls in $2^x$ Teilpulse unterteilen und zwar so, daß die $n=4^x$ Einzelpulse sukzessive auf die $2^x$ Teilpulse verteilt werden:

| $m =$ | 1 | 2 | 3 | ... | $2^x$ | $2^x+1$ | $2^x+2$ | $2^x+3$ | ... | $2 \cdot 2^x$ | $...2^x \cdot 2^x$ |
|---|---|---|---|---|---|---|---|---|---|---|---|
| $1 =$ | 1 | 2 | 3 | ... | $2^x$ | 1 | 2 | 3 | | $2^x$ | $...2^x$ |

1 ist die jeweilige Nummer der $2^x$ Teilpulse.

Jeder der $2^x$ Teilpulse wird so aufgebaut, daß die zugehörigen Einzelpulse zu einem k exakt in Phase sind. Die Amplitude beträgt dann $2^x$. Da die Summe aller Amplituden über einen vollständigen Zyklus von $2^x$ Phaseninkrementen für jeden Teilpuls $= 2^x$ sein muß (s.o.), folgt zwangsläufig, daß die übrigen $2^x-1$ Amplituden gleich Null ein müssen. Die Teilpulse werden dann so kombiniert, daß diese Kohärenzbedingung für jeden Teilpuls zu einem anderen k erfüllt wird, so daß der Teilpuls 1 für k=1 Kohärenz zeigt, Teilpuls 2 für k=2... Teilpuls 1 wieder in $k=2^x$ usw.

4) $n = 2 \cdot 4^x$, $P_{k0} = 2^x \cdot \sqrt{2}$.

Hierbei zerlegt man den Gesamtpuls zunächst in 2 Teilpulse aus jeweils $4^x$ Einzelpulsen, wobei der eine Teilpuls alle Einzelpulse mit geraden m, der andere alle mit ungeraden m enthält. Diese werden dann in der unter 3) gegebenen Vorschrift so zerlegt, daß die Summe ihrer Teilamplituden homogenisiert und gleich $2^x$ ist. Die beiden Teilpulse werden dann so kombinierte, daß die Resultierenden der beiden Teilamplituden in allen k senkrecht aufeinander stehen.

Fig. 5 zeigt, daß die maximale Pulsamplitude über dem durch die aus den Amplitudenverhältnissen in der Pulsmitte liegenden Wert von $\sqrt{n}$ liegt, da außerhalb des Pulszentrums größere Werte auftreten. Durch numerische Evaluation des durch Gl. (5) beschriebenen Gleichungssystem lassen sich für beliebige Pulse in Abhängigkeit von $\omega_m$ die jeweiligen Phasenwinkel $\phi_m$ und Startphasen $\phi°_m$ mit minimaler Maximalamplitude fin-

den. Für praktische Fälle bietet der einfache Algorithmus der Homogenisierung der Zentralamplitude jedoch eine hinreichend gute Annäherung an die optimale Amplitude $P_{k0} = \sqrt{n}$.

Die drastische Reduktion der Pulsleistung ermöglicht die Durchführung von Experimenten mit einer großen Zahl simultan angeregter Scheiben (n>8).

Dabei soll noch darauf hingewiesen werden, daß dieses Verfahren auch bei der Aufnahme mehrerer Schichten aus einem möglichst lückenlosen Volumen gegenüber 3D-Verfahren bezüglich seiner Abbildungseigenschaften Vorteile aufweist. Diese Vorteile sind in den Abbildungseigenschaften der diskreten Fouriertransformation begründet. Die Abbildung eines einzelnen Bildpunktes ("Voxels") wird dabei von der sogenannten Point-spread-Funktion wiedergegeben. Da ein Punkt bei diskreter Fouriertransformation eine endliche Ausdehnung entsprechend der Voxelgröße besitzt, ist die Abbildung eines Punktes durch die Abbildung des Voxels gegeben. Aus der Fouriertransformation eines rechteckigen Intensitätsprofils im Voxel ergibt sich so eine sinc-Funktion (=$\sin(2 \cdot \pi \cdot x)/(2 \cdot \pi \cdot x)$), wobei x die Voxelgröße kennzeichnet. Diese Funktion hat auch außerhalb des Voxels einen Wert, der deutlich über Null liegt. Auf Grund des sehr langsamen Abklingens der sinc-Funktion ergibt sich so eine Kontamination bis in weit entfernte Voxel. Bereits im eindimensionalen Fall ergibt sich für eine homogene Signalverteilung eine Kontamination von 41%, d.h. nur 59% des beobachteten Signals stammen aus dem beobachteten Voxel.

Die physikalische Ursache für diese Kontamination liegt in der Tatsache, daß durch den Phasengradienten eine Dephasierung der Signale auch innerhalb eines Voxels stattfindet. Diese Dephasierung wird in dem beschriebenen Verfahren vermieden, da hier sämtliche Spins in der jeweiligen Scheibe denselben Phasenversatz erfahren. Das Kontaminationsproblem exisitiert also in Bezug auf dieses Verfahren nicht.

Dieser Gesichtspunkt ist nicht nur für die Bildgebung von Bedeutung, sondern vor allem auch für das Verfahren des sogenannten chemical-shift-imaging, welches eine räumliche Auflösung der MR-Signale ausschließlich durch Phasenkodierung, also ohne Lesegradient, erzielt.

Hierbei stellt sich das Kontaminationsproblem besonders drastisch, da oft sehr kleine Signale in einem Voxel beobachtet werden sollen, wenn im Nachbarvoxel eine sehr große Konzentration von Spins mit gleichem Signal existieren, so daß schon geringe Kontamination das eigentliche Meßergbnis überdeckt.

Die Anwendung des beschriebenen Verfahrens vermeidet dieses Problem, wobei das Prinzip der Phasenkodierung durch die Pulsphase auch in 2- oder 3-dimensionaler Weise angewendet werden kann. Für den Fall einer 2D-Phasenkodierung kann die Anregung durch einen wie oben beschriebenen phasenmodulierten 90°-Puls vorgenommen werden und eine Refokussierung ebenfalls durch einen phasenmodulierten 180°-Puls erfolgen. Hierbei muß beachtet werden, daß eine Phasendifferenz von $\psi$ zwischen dem 90°- und dem 180°-Puls zu einer Phasenverschiebung um $2.\psi$ im resultierenden Spin-Echo führt, so daß die Phasen des Refokussierungspulses gegenüber den Tabellen 1 - 3 halbiert werden müssen. Eine vollständige 2D-Kodierung wird dann so erreichte, daß zunächst die Phase eines der beiden Pulse festgehalten wird und die des anderen k-mal unterschiedlich angewandt wird. Anschliessend wird die Prozedur nach Fortschalten des ersteren Pulses k-mal wiederholt.

## Patentansprüche

1. Verfahren zur simultanen Messung von Spin-Resonanzsignalen, insbesondere NMR-Signalen,
   aus n Schichten unterschiedlicher Tiefe z in einem Meßvolumen,
   welches einem homogenen Magnetfeld in Z-Richtung und
   periodisch aufeinanderfolgenden Sequenzen von pulsförmig angelegten Gradientenfeldern
   sowie zu den Gradientenfeldern zeitlich synchronisierten, zusammengesetzten HF-Anregungspulsen $P_k$ ausgesetzt wird,
   die jeweils aus einem einzigen, aus der Überlagerung mehrerer unterschiedlicher Frequenzen aufgebauten HF-Puls bestehen, und deren n Einzelkomponenten $P_m$ aufgrund ihrer jeweiligen Frequenz $\omega_m$ selektiv in einer bestimmten Schicht m des Meßvolumens eine Spin-Resonanz mit der Larmorfrequenz $\omega_m$ anregen, wobei
   eine räumliche Variation der Larmorfrequenz $\omega_m$ in Z-Richtung durch Anlegen eines Schichtselektionsgradienten bewirkt wird,
   wobei die Einzelkomponenten $P_m$ des zusammengesetzten HF-Anregungspulses $P_k$ jeweils einen Phasenversatz $\phi_m$ aufweisen, der von einer Sequenz zur nächsten durch sukzessive Addition eines für jede Einzelkomponente $P_m$ individuellen, konstanten Phaseninkrementes $\Delta\phi_m$ modulo 360° variiert wird,
   und wobei ein vollständiger Meßzyklus aus n oder einem ganzzahligen Vielfachen von n Sequenzen besteht,
   deren Meßsignale einer Fourier-Transformation unterworfen werden, die auch eine Transformation bezüglich der durch die Anregungspulse vorgenommenen Phasenkodierung der unterschiedlichen Schichten beinhaltet,
dadurch gekennzeichnet, daß der Phasenversatz $\phi_m$ der n Einzelkomponenten $P_m$ in der ersten Sequenz des Meßzyklus den Wert einer Startphase $\phi^0_m$ annimmt, und daß die n Startphasen $\phi^0_m$ derart gewählt werden, daß in jeder Sequenz sich mindestens ein Phasenversatz $\phi_m$ von den anderen Phasenversätzen der Sequenz unterscheidet, und zwar derart, daß die aus einer vektoriellen Addition der Amplitude der Einzelkomponenten $P_m$ an einem dem Zentrum des jeweiligen Pulses entsprechenden Zeitpunkt $t_0$ resultierende Gesamtamplitude des HF-Anregungspulses $P_k$ bei allen Sequenzen gleich ist.

2. Verfahren nach Anspruch 1, dadurch gekennzeichnet, daß mittels eines bipolaren Phasenkodiergradienten nach dem Fourier-Flow-Verfahren Flußgeschwindigkeiten eines im Meßvolumen strömenden Mediums schichtselektiv bestimmt werden.

3. Verfahren nach Anspruch 2, dadurch gekennzeichnet, daß durch Aufnahme einer Vielzahl von Strömungsprofilen eine qualitative räumliche Darstellung der durchströmten Volumina, insbesondere von Blutgefäßen in Form eines MR-Angiogramms, erreicht wird.

4. Verfahren nach Anspruch 2 oder 3, dadurch gekennzeichnet, daß die Sequenz in cine-mode mit dem EKG-Zyklus synchron läuft.

5. Verfahren nach Anspruch 1, dadurch gekennzeichnet, daß die Sequenzen Bildaufnahmesequenzen nach dem Gradientenecho oder Spin-echo-2DFT-Verfahren sind, wobei das Beobachtungsfenster jeder Schicht im Falle der Spin-echo Sequenz durch einen in Richtung des Phasengradienten scheibenselektiven Anregungs- oder Refokussierungspuls eingeschränkt wird.

6. Verfahren nach Anspruch 5, dadurch gekennzeichnet, daß die Aufnahme in EKG-getriggertem Aufnahmemodus durchgeführt wird.

7. Verfahren nach Anspruch 5 oder 6, dadurch gekennzeichnet, daß die Phasenkodierung für die 2DFT-Bildrekonstruktion ausschließlich über die Phasenmodulation der Pulse erfolgt.

8. Verfahren nach einem der vorhergehenden Ansprüche, dadurch gekennzeichnet, daß die räumliche Auflösung der Spin-Resonanzsignale ausschließlich durch Phasenmodulation der HF-Anregungspulse $P_k$ in einem gradientenkodierten chemicalshift-imaging-Verfahren bewirkt wird.

## Claims

1. A method for the simultaneous measurement of spin resonance signals, in particular NMR signals from n layers located at different depths z in a measuring volume which is subjected to a homogeneous magnetic field in the Z direction and to successive sequences of pulse-shaped gradient fields as well as to multiple-component rf excitation pulses $P_k$ that are synchronized in time with the gradient fields which, in each case, comprise one single rf pulse built-up from an overlap of a plurality of different frequencies, and whose n components $P_m$ excite, due to their respective frequencies $\omega_m$, a spin resonance of Larmor frequency $\omega_m$ in a particular slice m of the measuring volume, a variation in space of the Larmor frequency $\omega_m$ being effected in the Z direction by application of a slice-selection gradient, whereby the individual components $P_m$ of the composite rf excitation pulse $P_k$, in each case, exhibit a phase shift $\Phi_m$ which is varied from one sequence to the next by successive addition of individual constant phase increments $\Delta\Phi_m$ modulo 360° for each individual component $P_m$, whereby a complete measurement cycle comprises n or a whole number multiple of n sequences whose measurement signals are subjected to a Fourier transformation which also includes a transformation with respect to the phase encoding of the differing slices effected by means of the excitation pulse,
characterized in that
the phase shift $\Phi_m$ of the n individual components $P_m$ in the first sequence of the measurement cycle assumes a value of a starting phase $\Phi^0_m$, whereby the n starting phases $\phi^0_m$ are chosen such that, in each sequence, at least one phase shift $\Phi_m$ differs from the other phase shifts of the sequence in such a fashion that the entire amplitude of the rf excitation pulse $P_k$ resulting at a time $t_0$ corresponding to the center of the corresponding pulse from the vectorial addition of the amplitudes of the individual components $P_m$ is the same for all sequences.

2. The method of claim 1, characterized in that flow rates of a medium flowing through the measuring volume are measured in a slice-selective manner by means of a bipolar phase encoding gradient according to the Fourier Flow Method.

3. A method according to claim 2, characterized in that qualitative three-dimensional representation of the volumes passed by the following medium, can be achieved by recording a plurality of flow profiles, in particular of blood vessels, in the form of an MR angiogram.

4. A method according to claim 2 or 3, characterized in that the gradient sequence develops in synchronism with the ECG cycle in the cine mode.

5. A method according to claim 1, characterized in that sequences are image-recording sequences according to the gradient echo or the spin echo 2DFT method, the observation window of each layer being restricted, in the case of the spin echo sequence, by an excitation or refocusing pulse which is slice-selective in the direction of the phase gradient.

6. A method according to claim 5, characterized in that the measurement is carried out in the ECG-triggered mode.

7. A method according to claim 5 or 6, characterized in that the phase encoding for the 2DFT image reconstruction is effected exclusively through phase modulation of the pulses.

8. A method according to one of the preceding claims, characterized in that the spatial resolution of the spin resonance signals is effected exclusively through phase modulation of the rf excitation pulse $P_k$ in a gradient encoding chemical shift imaging method.

## Revendications

1. Procédé pour la mesure simultanée de signaux de résonance de spins, et en particulier de signaux de résonance magnétique nucléaire, à partir de n coupes dont la profondeur z est différente dans un volume à analyser, celui-ci étant soumis à un champ magnétique homogène dans la direction de l'axe des Z et à des séquences de champs variables appliqués sous la forme d'impulsions qui se succèdent périodiquement, ainsi qu'à des impulsions d'excitation à haute fréquence combinées $P_k$ qui sont synchronisées dans le temps avec les champs variables, qui se composent à chaque fois d'une unique impulsion à haute fréquence constituée à partir de la super-position de plusieurs fréquences différentes et dont les n composantes individuelles $P_m$ excitent sélectivement, dans une coupe déterminée m du volume à analyser, et du fait de leur fréquence respective $\omega_m$, une résonance de spins dont la fréquence de Larmor est $\omega_m$,

dans lequel une modification dans l'espace de la fréquence de Larmor $\omega_m$ dans la direction de l'axe des Z est produite par l'application d'un champ variable de sélection de la coupe,

dans lequel les composantes individuelles $P_m$ de l'impulsion d'excitation à haute fréquence combinée $P_k$ présentent chacune un déphasage $\phi_m$ que l'on fait varier d'une séquence à la suivante par des additions successives d'un incrément de phase $\Delta\phi_m$ modulo 360° qui est constant et propre à chaque composante individuelle $P_m$,

et dans lequel un cycle de mesure complet est constitué par un nombre de séquences égal à n ou à un multiple entier de n dont les signaux de mesure sont soumis à une transformation de Fourier, celle-ci contenant également une transformation concernant le codage des phases des différentes coupes qui est réalisé par les impulsions d'excitation,

caractérisé par le fait que le déphasage $\phi_m$ des n composantes individuelles $P_m$ dans la première séquence du cycle de mesure prend la valeur d'une phase de départ $\phi^\circ_m$, et par le fait que les n phases de départ $\phi^\circ_m$ sont choisies d'une manière telle que, dans chaque séquence, au moins un déphasage $\phi_m$ diffère des autres décalages de la séquence, et ce, d'une manière telle que l'amplitude totale de l'impulsion d'excitation à haute fréquence $P_k$ qui résulte d'une somme vectorielle de l'amplitude des composantes individuelles $P_m$ à un instant $t_o$ correspondant au centre de chaque impulsion soit la même pour toutes les séquences.

2. Procédé selon la revendication 1, caractérisé par le fait qu'au moyen d'un gradient bipolaire de codage des phases obtenu par le procédé de mesure de l'écoulement par transformation de Fourier, on détermine sélectivement, en fonction des coupes, des vitesses d'écoulement d'un milieu qui s'écoule dans le volume à analyser.

3. Procédé selon la revendication 2, caractérisé par le fait qu'au moyen de l'enregistrement d'une pluralité de profils d'écoulement, on obtient une représentation qualitative dans l'espace des volumes traversés, et en particulier de vaisseaux sanguins, sous la forme d'un angiogramme par résonance magnétique.

4. Procédé selon la revendication 2 ou 3, caractérisé par le fait que la séquence se déroule en synchronisme avec le cycle d'électrocardiogramme dans un mode "cinématographique".

5. Procédé selon la revendication 2, caractérisé par le fait que les séquences sont constituées par des séquences de prise de vue selon le procédé d'écho de champs variables ou selon le procédé d'écho de spins par transformation de Fourier à deux dimensions, la fenêtre d'observation de chaque coupe étant délimitée, dans le cas de la séquence par écho de spins, par une impulsion d'excitation ou de refocalisation qui est sélective vis-à-vis des coupes dans la direction du gradient de phase.

6. Procédé selon la revendication 5, caractérisé par le fait que la prise de vue est réalisée selon un mode de prise de vue excitée par un électrocardiogramme.

7. Procédé selon la revendication 5 ou 6, caractérisé par le fait que le codage de phase pour la reconstitution de l'image par transformation de Fourier à deux dimensions a lieu exclusivement par la modulation en phase des impulsions.

8. Procédé selon l'une des revendications précédentes, caractérisé par le fait que la résolution dans l'espace des signaux de résonance de spins est produite exclusivement par la modulation en phase des impulsions d'excitation à haute fréquence $P_k$ dans un procédé d'imagerie à déphasage chimique codée par les champs variables.

Fig. 1

Fig. 2a

Fig. 2b

Fig. 2c

Fig. 3a

Fig. 3 b

Fig. 4

Fig. 5

EP 0 413 266 B1